# EUROPEAN PATENT APPLICATION

(11) **EP 2 555 592 A1**
(43) Date of publication of application: **06.02.2013**
(21) Application number: 11762692.9
(22) Date of filing: 25.03.2011
(51) Int. Cl.: H05B 33/10, H01L 51/50

(54) **METHOD OF MANUFACTURING LIGHT-EMITTING APPARATUS**

(30) Priority: 29.03.2010 JP 2010074567
(71) Applicant: Sumitomo Chemical Company Limited, Tokyo 104-8260 (JP)
(72) Inventor: GODA, Tadashi, Tsukuba-shi Ibaraki 305-0821 (JP)
(74) Representative: Jackson, Martin Peter
(86) International application number: PCT/JP2011/057298
(87) International publication number: WO 2011/122461

(57) **Abstract**

Provided is a method for manufacturing a light-emitting device, by which method a light-emitting device (21) can be manufactured with ease by selectively removing a thin film that is formed outside a light-emitting region by ink application.
The method for manufacturing a light-emitting device is a method to manufacture a light-emitting device that includes a supporting substrate and a plurality of organic electroluminescent (EL) elements (22) that are provided at a light-emitting region defined on the supporting substrate, the element including a first electrode (12), a second electrode, and an organic EL layer provided between the first electrode and the second electrode. The method includes: preparing the supporting substrate that is provided with the first electrode, supplying an ink containing the material of the organic EL layer onto the supporting substrate to form a thin film made of the ink in the light-emitting region and a region outside the light-emitting region on the supporting substrate, making the thin film in the light-emitting region insoluble, removing the thin film outside the light-emitting region by cleaning, and forming the second electrode.

## Description

### TECHNICAL FIELD

The present invention relates to a method for manufacturing a light-emitting device.

### BACKGROUND ART

There are various display devices with different structures and principles, and one of these display devices in which an organic electroluminescent (organic EL) element works as a light source for a pixel is currently directed toward practical use.

This display device comprises a plurality of organic EL elements arranged on a supporting substrate. On the supporting substrate, a partition is generally provided for defining a compartment in which the organic EL element is provided. The organic EL elements are provided in proper alignment each in the compartment defined by the partition.

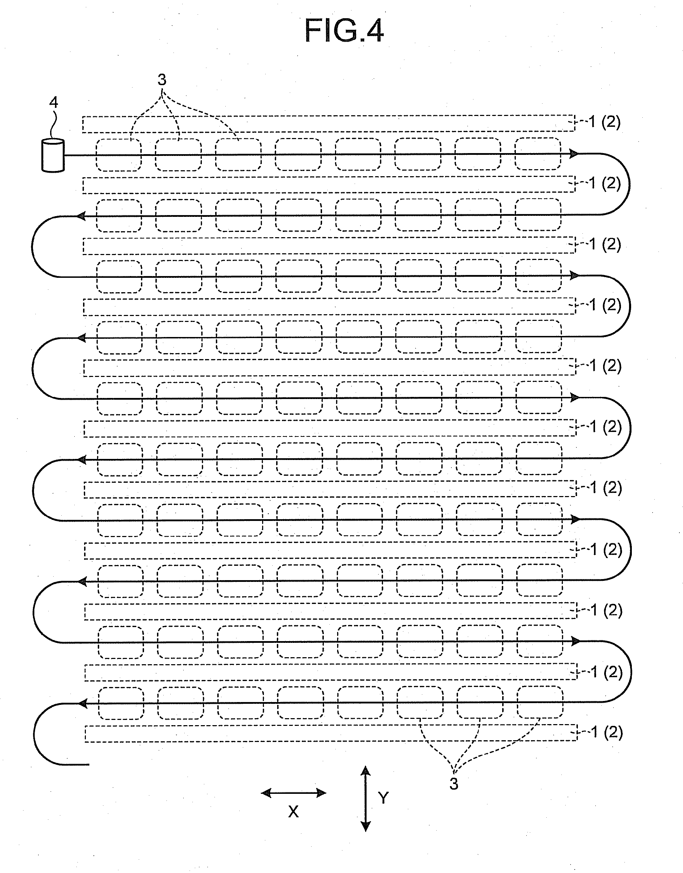

FIG. 4 schematically illustrates an aspect to supply an ink by a nozzle printing method. As illustrated in FIG. 4, for example, where a partition 2 composed of a plurality of partition members 1 extending in a prescribed line direction X is provided on a supporting substrate, a plurality of organic EL elements 3 are provided between the partition members 1 to be spaced from each other at prescribed intervals in a column direction Y.

An organic EL element has a pair of electrodes and an organic EL layer interposed between the pair of electrodes, in a way that each of the constituents is sequentially stacked on one another.

The organic EL layer that constitutes the organic EL element can be formed by a coating method. That is, an ink containing the material of the organic EL layer is applied by a prescribed coating method to form a film, which is then solidified to form the organic EL layer.

At the step of forming the organic EL layer, the ink has only to be applied for film formation to a region where the organic EL element is to be formed (hereinafter, also referred to as a light-emitting region). Depending on the coating method used, however, the ink can be applied for film formation not only to the light-emitting region but also to a region outside the light-emitting region. In the case of applying the ink for film formation by a spin coating method or a nozzle printing method, for example, the ink is also applied for film formation to the region outside the light-emitting region.

In FIG. 4, the locus of a nozzle 4 over the supporting substrate is illustrated by a solid line with arrows. In a nozzle printing method, the nozzle 4 through which the ink is continuously supplied is arranged on the supporting substrate and is moved back and forth in a line direction X while continuously supplying the ink, during which at the time when the nozzle 4 is turned back toward the opposite direction, the supporting substrate is moved by one line in a column direction Y, whereby the ink is supplied to each line. Thus, in a nozzle printing method, by which the ink is continuously supplied with a single stroke, the ink is inevitably supplied to the region outside the light-emitting region as well.

The ink applied for film formation to the region outside the light-emitting region is usually removed after ink application. This is because the ink applied for film forming to the region outside the light-emitting region potentially leads to degradation in the features of the display device. When the ink is applied to a region where an adhesive member, which generally serves to bond the supporting substrate and a sealing substrate together for sealing, is to be provided, for example, adhesion and hermeticity may degrade. In the case where the ink covers a trace that is provided outside the light-emitting region on the supporting substrate, the trace might be undesirably short-circuited. For these reasons, in conventional techniques, the ink applied for film forming to the region outside the light-emitting region is wiped off and removed (Patent Document 1, for example).

### RELATED ART DOCUMENTS

### Patent Document

Patent Document 1: JP 2006-216253 A

### DISCLOSURE OF INVENTION

### PROBLEM TO BE SOLVED BY THE INVENTION

Conventional techniques where an ink is removed by operating a wiping member in a region to which the ink is applied for film formation have a problem that repeated wiping-off of the ink leads to the adherence of the ink to the wiping member, resulting in gradual degradation in the performance of the wiping member to wipe off the ink, whereby continuous and complete wiping-off of the ink cannot be achieved. In addition, at the time of wiping off the ink, a particle can be generated from a thin film that is solidifying or a thin film that is solidified, and may contaminate an organic EL layer. An unintended particle may also be generated by a device for operating the wiping member, and may contaminate an organic EL layer.

Thus, a purpose of the present invention is to provide a method for manufacturing a light-emitting device, by which method the light-emitting device can be manufactured with ease by a novel method of selectively removing a thin film that is formed in a region outside the light-emitting region by ink application.

### MEANS FOR SOLVING PROBLEM

The present invention provides the following [1] to [6].
[1] A method for manufacturing a light-emitting device comprising a supporting substrate, an organic electroluminescent elements that are provided at a light-emitting region defined on the supporting substrate, the element comprising a first electrode, a second electrode, and an organic electroluminescent layer interposed between the first electrode and the second electrode, the method comprising the steps of:
   preparing the supporting substrate that has the first electrode;
   supplying a ink that comprises a material to be the organic electroluminescent layer to the supporting substrate, and forming a thin film comprising the ink on the light-emitting region and a region outside the light-emitting region;
   making the thin film in the light-emitting region insoluble ;
   removing the thin film in the region except the light-emitting region by cleaning; and
   forming the second electrode.
[2] The method for manufacturing the light-emitting device according to above [1],
   wherein, at the step of forming a thin film comprising the ink, the ink comprising a polymer compound is supplied, and
   at the step of making the thin film insoluble, the thin film in the light-emitting region is made insoluble by polymerizing the polymer compound.
[3] The method for manufacturing the light-emitting device according to above [1] or [2],
   wherein, at the step of making the thin film insoluble, the thin film in the light-emitting region is made insoluble by light radiation.
[4] The method for manufacturing the light-emitting device according to any one of above [1] to [3],
   wherein at the step of making the thin film insoluble, the thin film in the light-emitting region is made insoluble by heating.
[5] The method for manufacturing the light-emitting device according to above [4],
   wherein the thin film in the light-emitting region is heated by near-infrared radiation.
[6] The method for manufacturing the light-emitting device according to any one of above [1] to [5],
   wherein, at the step of forming the thin film, the ink is supplied by a nozzle printing method.

### EFFECT OF THE INVENTION

According to the present invention, a light-emitting device can be manufactured with ease by a novel method of selectively removing a thin film that is formed in a region outside the light-emitting region by ink application.

### BRIEF DESCRIPTION OF DRAWINGS

FIG. 1 is a plan view to schematically illustrate a light-emitting device of a present embodiment.
FIG. 2 is an enlarged cross-sectional view to schematically illustrate the light-emitting device.
FIG. 3A is a schematic for explaining a step of making a thin film insoluble and further cleaning the film.
FIG. 3B is a schematic for explaining a step of making a thin film insoluble and further cleaning the film.
FIG. 3C is a schematic for explaining a step of making a thin film insoluble and further cleaning the film.
FIG. 4 is a view to schematically illustrate an aspect to supply an ink by a nozzle printing method.

### DESCRIPTION OF EMBODIMENTS

An embodiment of the present invention will be described below referring to drawings. In the description below, the shapes, the sizes, and the arrangements of constituents in each drawing are schematically illustrated to the extent to enable understanding of the invention, and the present invention is not particularly limited by these. The same constituent in each drawing is sometimes illustrated with the same reference numeral to omit an overlapping explanation.
A method for manufacturing a display device of the present invention is a method for manufacturing a light-emitting device that comprises a supporting substrate and a plurality of organic EL elements that are provided at a light-emitting region defined on the supporting substrate, the element comprising a first electrode, a second electrode, and an organic EL layer provided between the first electrode and the second electrode. The method comprises: preparing the supporting substrate that is provided with the first electrode, supplying an ink comprising the material of the organic EL layer onto the supporting substrate to form a thin film made of the ink in the light-emitting region and a region outside the light-emitting region on the supporting substrate, making the thin film in the light-emitting region insoluble, removing the thin film outside the light-emitting region by cleaning, and forming the second electrode.

Light-emitting devices are utilized in display devices and illuminating devices, for example, and most display devices are of an active matrix-driven type or a passive matrix-driven type. The present invention can be applied to the display devices of either type. The present embodiment describes a light-emitting device that is to be applied to an active matrix-driven display device. In the present embodiment, an organic EL element that works as a light source for a pixel in the display device is described. The light-emitting device may comprise an organic EL element that works as a backlight, for example. In the present embodiment, a light-emitting device with a plurality of organic EL elements is described. However, the present invention can be applied to a light-emitting device with a single organic EL element.

### <Structure of light-emitting device>

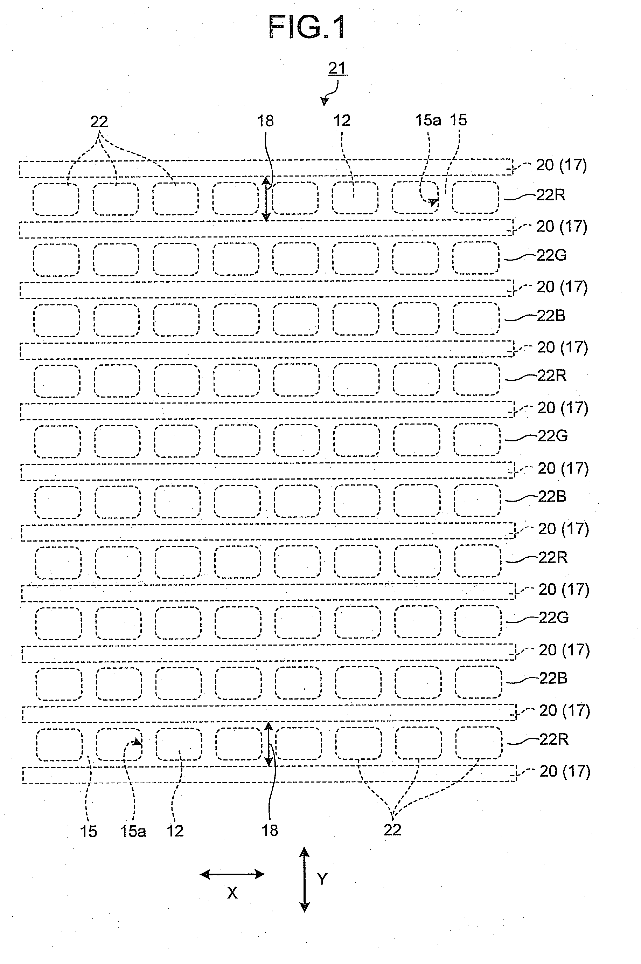

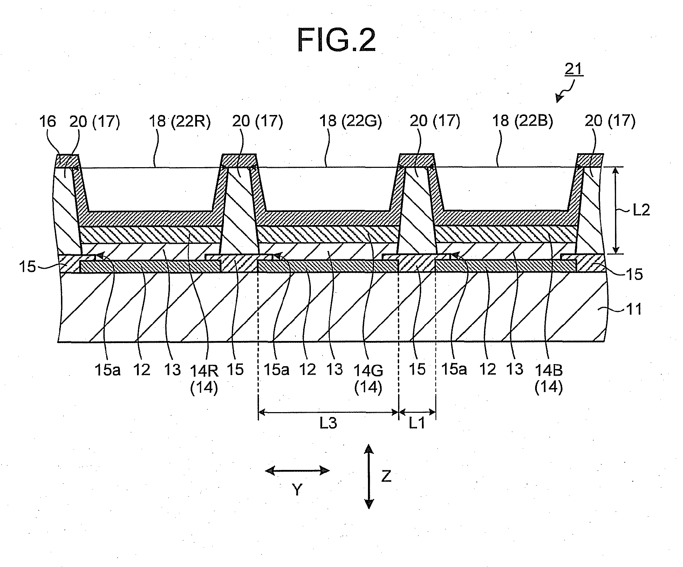

First, the structure of the light-emitting device is described referring to FIGS. 1 and 2. FIG. 1 is a plan view to schematically illustrate a light-emitting device of the present embodiment. FIG. 2 is an enlarged cross-sectional view to schematically illustrate the light-emitting device.
As illustrated in FIGS. 1 and 2, a light-emitting device 21 principally comprises a supporting substrate 11, and a plurality of organic EL elements 22 that are provided in a light-emitting region defined on the supporting substrate.

The light-emitting region in the present specification is a region where a plurality of organic EL elements are provided, and in a display device, corresponds to an image display region for displaying image information. In the present embodiment, a prescribed compartment is defined on the supporting substrate 11, and in the compartment defined on the supporting substrate 11, the organic EL elements 22 are arranged. In the present embodiment, a partition 17 for defining the compartment defined on the supporting substrate 11 is provided on the supporting substrate 11.

The organic EL elements 22 are arranged in prescribed alignment each in the prescribed compartment defined on the supporting substrate 11. The shape of the partition 17 for defining the compartment is designed depending on the shape of the compartment defined on the supporting substrate 11. In the case where a matrix-shape compartment is defined on the supporting substrate 11, for example, a grid-shape partition is provided on the supporting substrate to serve as a partition for defining the matrix-shape compartment. In the case where a stripe-shape compartment is defined on the supporting substrate 11, a stripe-shape partition 17 is provided on the supporting substrate to serve as a partition for defining the stripe-shape compartment. The present invention can be applied to a light-emitting device of any form regardless of the presence or absence of the partition and the shape of the partition. In the present embodiment, the case where the stripe-shape partition 17 is provided on the supporting substrate 11 is described. That is, the partition 17 of the present embodiment is composed of a plurality of partition members 20 each extending in a prescribed line direction X on the supporting substrate 11. The partition members 20 are arranged at prescribed intervals in a column direction Y that is different from the line direction X. The line direction X and the column direction Y of the present embodiment mean directions that are perpendicular to each other and are each perpendicular to a thickness direction Z of the supporting substrate 11. A pair of partition members 20 that are adjacent to each other in the column direction Y and the supporting substrate 11 define a concave, which is also referred to as a concave portion 18 hereinafter. On the supporting substrate 11, a plurality of concave portions 18 are defined corresponding to the plurality of partition members 20. The concave portions 18 of the present embodiment correspond to the compartments defined by the partitions.

In the present embodiment, an insulating film 15 is further provided between the supporting substrate 11 and the partition 17. The insulating film 15 is provided, for example, in order to ensure electrical insulation among the organic EL elements 22 that are adjacent to each other in the line direction X or in the column direction Y. The insulating film 15 of the present embodiment is formed in a grid-shape. The grid-shape insulating film 15 is integrally formed by a plurality of strip-shape parts extending in the line direction X and a plurality of strip-shape parts extending in the column direction Y. In other words, the insulating film 15 is a thin film with an electrical insulating property that has many openings 15a formed in a matrix.
The opening 15a of the insulating film 15 is formed at a position that overlaps the position of the organic EL element 22 as viewed from a thickness direction of the supporting substrate (hereinafter, also referred to as "in a planar view"). The opening 15a of the insulating film 15 is formed so as to almost coincide in a planar view with the position of a first electrode 12 to be described below, and to have a substantially rectangular shape, an oval shape, a substantially circular shape, a substantially elliptical shape, or the like, for example. The grid-shape insulating film 15 is formed to cover, in a planar view, the periphery of the first electrode 12 while exposing part of the first electrode 12. The partition members 20 described above are provided on the strip-shape parts of the insulating film 15 that extend in the line direction X.

The organic EL element 22 is provided in the concave portion 18 defined by the partition. In the present embodiment, the organic EL elements 22 are provided between the partition members 20, namely in the concave portions 18, that are adjacent to each other in the column direction Y so as to be spaced from each other at prescribed intervals in the line direction X. That is, in the present embodiment, the organic EL elements 22 are arranged in a matrix on the supporting substrate 11 at prescribed intervals in the line direction X and at prescribed intervals in the column direction Y. The organic EL elements 22 are not required to be physically farther from each other and have only to be electrically insulated against each other so as to be individually driven. For this reason, some of the layers (the first electrode 12, a second electrode 16, and the organic EL layer) that form the organic EL element 22 may be physically connected to other organic EL elements 22.

The organic EL element 22 is composed of the first electrode 12, a hole injection layer 13 and a light-emitting layer 14 that constitute the organic EL layer, and the second electrode 16 arranged in this order in a way that the first electrode 12 is closer to the supporting substrate 11.

The first electrode 12 and the second electrode 16 constitute a pair of electrodes composed of an anode and a cathode. That is, one of the first electrode 12 and the second electrode 16 is provided as the anode while the other is provided as the cathode. The first electrode 12 of the first electrode 12 and the second electrode 16 is arranged closer to the supporting substrate 11, while the second electrode 16 is arranged farther from the supporting substrate 11 than the first electrode 12.

The organic EL element 22 has one or more organic EL layers. The organic EL layer means all the layers interposed between the first electrode 12 and the second electrode 16. The organic EL element 22 has at least one or more light-emitting layers 14 as the organic EL layer. Between the first electrode 12 and the second electrode 16, a prescribed layer is provided, where appropriate, in addition to the light-emitting layer 14. For example, between the anode and the light-emitting layer 14, the hole injection layer, a hole transport layer, an electron block layer, and the like are provided as the organic EL layer, while between the light-emitting layer 14 and the cathode, a hole block layer, an electron transport layer, an electron injection layer, and the like are provided as the organic EL layer.

The organic EL element 22 of the present embodiment includes, as the organic EL layer, the hole injection layer 13 between the first electrode 12 and the light-emitting layer 14.

Described below as an embodiment is the organic EL element 22 that has the first electrode 12 that works as an anode, the hole injection layer 13, the light-emitting layer 14, and the second electrode 16 that works as a cathode, stacked in this order in a way that the first electrode 12 is closer to a supporting substrate 11.

In the light-emitting device 21 of the present embodiment, which is of an active matrix-driven type, the first electrode 12 is provided to each organic EL element 22. That is, as many first electrodes 12 as the organic EL elements 22 are provided on the supporting substrate 11. The first electrode 12 is, for example, a thin film that is formed to be substantially rectangular in a planar view. The first electrode 12 is provided in a matrix on the supporting substrate 11, corresponding to the position at which the organic EL element is provided. The first electrodes 12 are arranged at prescribed intervals in the line direction X and at prescribed intervals in the column direction Y.
The first electrode 12 is provided, in a planar view, between the partition members 20 that are adjacent to each other in the column direction Y so as to be spaced from each other at prescribed intervals in the line direction X.

As described above, the grid-shape insulating film 15 is formed in a way to cover, in a planar view, the periphery of the first electrode 12 while exposing part of the first electrode 12. That is, the insulating film 15 has the opening 15a above the first electrode 12, and part of the surface of the first electrode 12 is exposed through the opening 15a of the insulating film 15.

The hole injection layer 13 is arranged extending in the line direction X in a region that is sandwiched between the partition members 20. That is, the hole injection layer 13 is formed in a strip shape in the concave portion 18 defined by the partition members 20 that are adjacent to each other in the column direction Y, continuously across the organic EL elements 22 that are adjacent to each other in the line direction X.

The light-emitting layer 14 is provided extending in the line direction X in the region that is sandwiched between the partition members 20 facing each other. That is, the light-emitting layer 14 is formed in a strip shape in the concave portion 18 defined by the partition members 20 that are adjacent to each other in the column direction Y, continuously across the organic EL elements 22 that are adjacent to each other in the line direction X. The strip-shape light-emitting layer 14 is stacked on the strip-shape hole injection layer 13.

Although the present invention can be applied to monochrome display devices, the present embodiment describes application to color display devices. In a color display device, three kinds of organic EL elements 22 (22R, 22G, 22B) each of which emits light of either red, green, or blue are provided on the supporting substrate 11. The color display device can be made, for example, by repeatedly arranging the following lines (I), (II), and (III) in this order in the column direction Y.

(I) Line on which a plurality of organic EL elements 22R that emit red light are arranged at prescribed intervals in the line direction X
(II) Line on which a plurality of organic EL elements 22G that emit green light are arranged at prescribed intervals in the line direction X
(III) Line on which a plurality of organic EL elements 22B that emit blue light are arranged at prescribed intervals in the line direction X

Thus, in the case of forming the three kinds of organic EL elements each of which emits light of a different color, a light-emitting layer that emits light of the same color is usually formed for each kind of organic EL element. In the present embodiment, the following lines (i), (ii), and (iii) are repeatedly arranged in this order in the column direction Y.

(i) Line on which a light-emitting layer 14R that emits red light is provided
(ii) Line on which a light-emitting layer 14G that emits green light is provided
(iii) Line on which a light-emitting layer 14B that emits blue light is provided

In this case, each of the three kinds of strip-shape light-emitting layers 14 (14R, 14G, 14B) extending in the line direction X are sequentially stacked on the hole injection layer 13 so as to be spaced from the same kind of strip-shape light-emitting layer by two lines in the column direction Y.

The second electrode 16 is provided on the light-emitting layer 14. In the present embodiment, the second electrode 16 is continuously formed across the organic EL elements 22 to serve as an electrode common to the organic EL elements 22. The second electrode 16 is formed all over the light-emitting layer 14 and the partition 17 so that the electrode on the light-emitting layer 14 and the electrode on the partition 17 are continued.

### <Method for Manufacturing Light-Emitting Device>

Next, the method for manufacturing the light-emitting device is described.

### (Step of Preparing Supporting Substrate)

In this step, the supporting substrate 11 on which the first electrode 12 is provided is prepared. In an active matrix-driven display device, a substrate on which a circuit for individually driving a plurality of organic EL elements is preformed can be used as the supporting substrate 11. For example, a substrate on which a thin film transistor (TFT), a capacitor, and the like are preformed can be used as the supporting substrate. The supporting substrate 11 on which the first electrode 12 is provided may be prepared by forming the first electrode 12 in this step as follows. However, the substrate on which the first electrode 12 is preformed may be commercially obtained to be used as the supporting substrate 11. Alternatively, a supporting substrate 11 on which the first electrode 12 and the partition 17 are preformed may also be commercially obtained to be used as the supporting substrate 11.

The first electrodes 12 are formed in a matrix-shape on the supporting substrate 11. The first electrode 12 is formed, for example, by forming a conductive thin film on all over the supporting substrate 11, and then patterning the conductive thin film to create a matrix-shape pattern by photolithography (in the following description, "photolithography" comprises a patterning step such as an etching step performed following a mask pattern-forming step). Alternatively, the first electrode 12 may also be patterned, for example, by arranging on the supporting substrate 11 a mask in which an opening is formed at a prescribed portion, and then selectively depositing a conductive material through the mask on a prescribed portion on the supporting substrate 11. The material of the first electrode 12 will be described below.

Next, the partition 17 is formed on the supporting substrate 11. In the present embodiment, the partition 17 composed of a plurality of partition members 20 is formed. The partition 17 is made of an organic substance or an inorganic substance. Examples of the organic substance that constitutes the partition 17 may include resins such as acrylic resins, phenol resins, and polyimide resins. Examples of the inorganic substance that constitutes the partition 17 may include SiOₓ and iNₓ.

The partition 17 is preferably made of an organic substance. The partition 17 is preferably lyophobic in order to hold an ink to be supplied to the concave portion 18 defined by the partition members 20 that are adjacent to each other, within the concave portion 18. Organic substances are generally more lyophobic to an ink than inorganic substances, and therefore by making the partition with an organic substance, the performance to hold the ink within the concave portion 18 can be enhanced.

In the case of forming the partition 17 made of an organic substance, for example, a positive or a negative photosensitive resin is applied to all over the surface, and then exposure is performed on a prescribed portion, followed by development and curing to form a plurality of partition members 20. As the photosensitive resin, a photoresist can be used. In the case of forming the partition 17 made of an inorganic substance, for example, a thin film made of an inorganic substance is formed all over the surface by a plasma CVD method, a sputtering method, or the like, and then a prescribed portion in the thin film is removed to form a plurality of partition members 20. The prescribed portion is removed by photolithography method, for example.

In the case of manufacturing the light-emitting device 21 that comprises the grid-shape insulating film 15, the insulating film 15 is formed prior to the step of forming the partition 17. The insulating film 15 can be formed in a grid shape using, for example, the material described above as the material of the partition 17 in the same method as in the step of forming the partition 17.

In the case of forming the insulating film 15 in addition to the partitions 17, the insulating film 15 is preferably made of an inorganic substance, which is more lyophilic than an organic substance. This is because the insulating film 15 that is lyophobic may repel an ink supplied to the concave portion 18 to dry the ink, which means the presence of the insulating film 15 may affect the uniformity of the organic EL layer to make it impossible to obtain a uniform organic EL layer.

The shape and the arrangement of the partition 17 are appropriately designed depending on the specification of the display device such as the number of pixels and resolution, easiness of forming, and the like. For example, a width L1 of the partition member 20 in the column direction Y is about 5 µm to 50 µm, a height L2 of the partition member 20 is about 0.5 µm to 5 µm, and an interval L3 between the partition members 20 that are adjacent to each other in the column direction Y, namely the width L3 of the concave portion 18 in the column direction Y, is about 10 µm to 200 µm. The width of the first electrode 12 in the line direction X and that in the column direction Y are each about 10 µm to 400 µm.

### (Step of Forming Thin Film Made of Ink)

In this step, an ink comprising the material of the organic EL layer (the hole injection layer 13 in the present embodiment) (hereinafter, the ink is also referred to as an ink for hole injection layer) is supplied onto the supporting substrate 11 to form a thin film, made of the ink for hole injection layer, in the light-emitting region and the region outside the light-emitting region of the supporting substrate 11.

In the present embodiment, the hole injection layer 13 that is common to all of the organic EL elements 22 is formed. Therefore, it is not necessary to supply the ink for hole injection layer only to the space between the partition members 20 that are adjacent to each other, and the ink for hole injection layer may be supplied to all over the surface. For this reason, the ink for hole injection layer may be supplied in any method. For example, the ink for hole injection layer can be supplied by a spin coating method, a slit coating method, an ink jet printing method, a nozzle printing method, a letterpress printing method, an intaglio printing method, or the like. A preferred method for supplying the ink for hole injection layer is a method by which the ink for hole injection layer can be uniformly supplied in a short period of time, and from this viewpoint, the spin coating method, the slit coating method, and the nozzle printing method are preferable. However, when the ink for hole injection layer is applied to all over the surface, the hole injection layer may be formed even on the partition 17, depending on the surface properties of the partition. In order to avoid this, it is sometimes preferable to supply the ink for hole injection layer only to the concave portion 18. In this case, the ink for hole injection layer is supplied by the coating method by which the ink for hole injection layer can be selectively supplied only to the concave portion 18. In the present embodiment, the ink for hole injection layer is supplied by the nozzle printing method, which is a coating method by which the ink for hole injection layer can be selectively supplied.

In the nozzle printing method, the ink for hole injection layer is continuously supplied to the lines (each of concave portions 18) with a single stroke. That is, a nozzle that is arranged above the supporting substrate 11 is moved back and forth in the line direction X while discharging the liquid-columnar ink for hole injection layer through the nozzle, during which at the time when the nozzle is turned back toward the opposite direction, the supporting substrate is moved by a prescribed distance in the column direction Y, whereby the ink for hole injection layer is supplied to each line. For example, the supporting substrate can be moved by one line in the column direction Y at the time when the nozzle is turned back toward the opposite direction, whereby the ink for hole injection layer can be supplied to all the lines.

More specifically, steps (1) to (4) can be repeated in this order while discharging the liquid-columnar ink for hole injection layer through the nozzle so as to supply the ink for hole injection layer to all the space (concave portion 18) between the partition members 20 that are adjacent to each other. The steps are as follows:
(1) Step of moving the nozzle from one end in the line direction X toward the other end,
(2) Step of moving the supporting substrate 11 by one line in one of the column directions Y,
(3) Step of moving the nozzle from the other end in the line direction X toward one end, and
(4) Step of moving the supporting substrate by one line in one of the column directions Y.

Thus, by supplying the ink for hole injection layer by a nozzle printing method, the thin film made of the ink for hole injection layer is formed in the light-emitting region and the region outside the light-emitting region on the supporting substrate 11.

### (Step of Making Thin Film Insoluble)

Next, the thin film made of the ink for hole injection layer is made insoluble. In this step, the thin film in the light-emitting region is made insoluble. To make the thin film insoluble means to make the thin film hard to dissolve in a solution to be used in cleaning, which is performed in a later step. In the case where the ink comprises a polymerizable compound, for example, the thin film can be made insoluble by polymerizing the polymerizable compound. In the case where the ink comprises no polymerizable compound, the thin film can still be made insoluble to some extent by heating the thin film at a prescribed temperature to vaporize a solvent.

The material of the hole injection layer that is extensively used at present is poly(3,4-ethylenedioxythiophene)/poly(styrenesulfonate) (PEDOT/PSS), which dissolves in water. Therefore, for example, an aqueous PEDOT/PSS solution can use for the ink for hole injection layer. The thin film made of the aqueous PEDOT/PSS solution is made insoluble by heating. The material of the hole injection layer will be described below.

The thin film in the light-emitting region can be made insoluble by applying prescribed energy. This is achieved by a method of irradiating the thin film with light having a prescribed wavelength or a method of applying thermal energy. For example, the thin film may be irradiated with a g-line (wavelength: 436 nm) and/or an i-line (wavelength: 365 nm) of an ultrahigh-pressure mercury lamp, a KrF excimer laser (wavelength: 248 nm), and/or an ArF excimer laser (wavelength: 193 nm) to polymerize the polymerizable compound with light energy. The thin film may be heated by near-infrared radiation at a wavelength of 700 nm to 3500 nm to polymerize the polymerizable compound with thermal energy. The near-infrared radiation may also be used to vaporize the solvent so as to make the thin film insoluble. The thin film may be heated by far-infrared radiation at a wavelength of 3500 nm to 20000 nm to polymerize the polymerizable compound with thermal energy. The far-infrared radiation may also be used to vaporize the solvent so as to make the thin film insoluble. Alternatively, the thin film may be heated with a hot plate or the like to polymerize the polymerizable compound by thermal energy or to vaporize the solvent so as to make the thin film insoluble. However, even though energy is intended to be applied only to the thin film in the display region, energy may also be applied to the thin film on the periphery of the display region, resulting in making part of the thin film outside the display region insoluble. In order to apply energy only to the thin film in display region, it is preferable to apply energy by a method by which energy can be locally applied. From this viewpoint, the above-mentioned method of irradiating the thin film with light having a prescribed wavelength is preferable, and energy application to the thin film is preferably performed by near-infrared radiation by which the thin film can be locally heated.

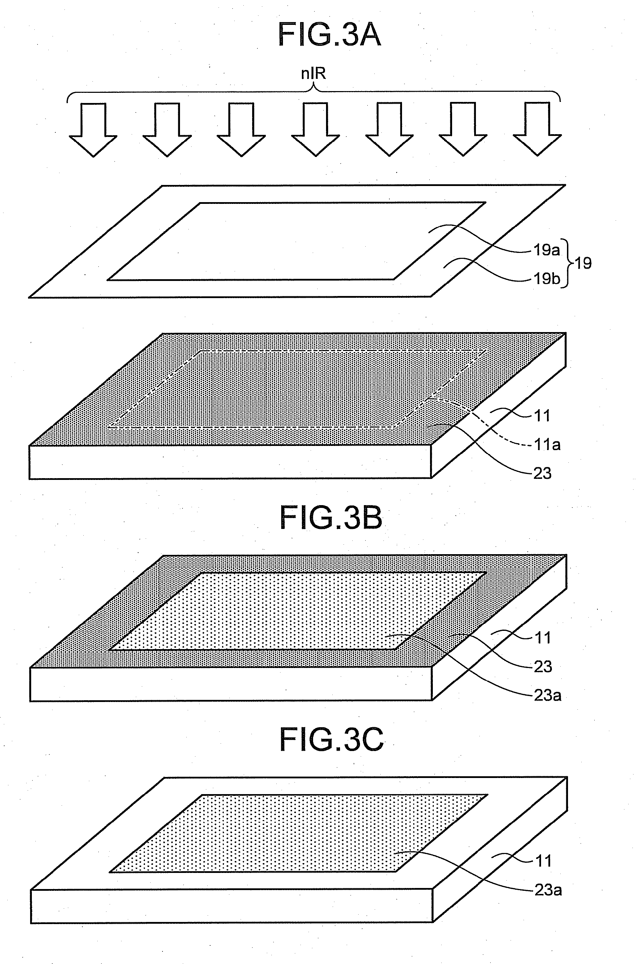

FIGS. 3A, 3B, and 3C are schematics for describing a step of making a thin film insoluble and further cleaning the film. The thin film is illustrated with a hatch pattern.
In the present embodiment, near-infrared light (nIR) is emitted to a thin film 23 in a light-emitting region 11a so as to make the thin film 23 in the light-emitting region 11a insoluble, thereby forming an insoluble thin film 23a. As illustrated in FIG. 3A, a region surrounded by a dashed-two dotted line is the light-emitting region 11a. First, a mask 19 having a region 19a that transmits near-infrared light and a region 19b that transmits no near-infrared light (nIR) is arranged on the supporting substrate 11 on which the thin film 23 is formed. In FIG. 3A, near-infrared light (nIR) being emitted is schematically illustrated by solid-white arrows. Near-infrared light (nIR) is emitted to the thin film 23 through the mask 19 so that the near-infrared light (nIR) is emitted only to the thin film 23 in the light-emitting region 11a. During this irradiation, the region 19b in the mask 19 that transmits no near-infrared light (nIR) cuts off part of the near-infrared light so that no near-infrared light (nIR) is emitted to the thin film 23 outside the light-emitting region 11a. Thus, only the thin film 23 in the light-emitting region 11a is heated, and therefore only the thin film 23 in the light-emitting region 11a is made insoluble, thereby forming the insoluble thin film 23a.
FIG. 3B schematically illustrates a supporting substrate after making the thin film 23 in the light-emitting region 11a insoluble. The insoluble thin film 23a and the thin film 23 that is not made insoluble are illustrated with a hatch pattern.

### (Step of Removing Thin Film outside Light-Emitting Region by Cleaning)

As illustrated in FIG. 3C, the thin film 23 outside the light-emitting region 11a is then removed by cleaning to leave only the insoluble thin film 23a on the supporting substrate 11. Examples of the method of cleaning may include a method of supplying a solvent onto the supporting substrate 11 and then removing the solvent (spin cleaning, for example), and a method of immersing the supporting substrate 11 in a solvent for a prescribed period of time, followed by taking the supporting substrate out of the solvent to dry. In cleaning, a solvent that dissolves the thin film 23 that is not made insoluble and does not dissolve the insoluble thin film 23a is used. In the case of forming the thin film 23 made of the aqueous PEDOT/PSS solution, water can be used, for example, as the solvent, whereby cleaning of the thin film outside the light-emitting region 11a can be achieved.

After the thin film 23 outside the light-emitting region 11a is removed by cleaning, the solvent in the insoluble thin film 23a in the light-emitting region 11a is removed, where appropriate. The solvent can be removed by air drying, heating and drying, vacuum drying, or the like, for example.

### (Step of Forming Light-emitting Layer)

Next, the light-emitting layer 14 is formed. As described above, in manufacturing a color display device, it is necessary to make three kinds of the organic EL elements 22 (22R, 22G, 22B). To do this, it is necessary that each line be applied with a different kind of material of the light-emitting layer 14. In the case where each line is formed with a different one among the three kinds of the light-emitting layers 14 (14R, 14G, 14B), for example, it is necessary that a red ink comprising a material emitting red light, a green ink comprising a material emitting green light, and a blue ink comprising a material emitting blue light be each applied, spaced from the ink of the same kind by two lines in the column direction Y. The red ink, the green ink, and the blue ink are thus sequentially applied each to a prescribed line, so that each light-emitting layer 14 can be formed.

The method of sequentially applying the red ink, the green ink, and the blue ink to a prescribed line (concave portion 18) may be any coating method by which the ink can be selectively supplied to the space between the partition members 20 that are adjacent to each other. The ink can be supplied, for example, by an ink jet printing method, a nozzle printing method, a letterpress printing method, an intaglio printing method, or the like. A preferred method of supplying the ink is a method by which the ink can be uniformly supplied in a short period of time. From this viewpoint, the nozzle printing method is preferable. In the present embodiment, as in the case of the method described above for forming the hole injection layer, the ink is supplied by the nozzle printing method.

More specifically, steps (1) to (4) can be repeated in this order while discharging the liquid-columnar red ink through the nozzle 4 so as to supply the red ink to the space (concave portion 18) that is between the partition members 20 that are adjacent to each other and is spaced by two lines in the column direction Y. The steps are as follows:
(1) Step of moving the nozzle 4 in the line direction X from one end of the concave portion 18 toward the other end,
(2) Step of moving the supporting substrate 11 by three lines in one of the column directions Y,
(3) Step of moving the nozzle 4 in the line direction X from the other end of the concave portion 18 toward one end, and
(4) Step of moving the supporting substrate by three lines in one of the column directions Y.

By supplying the green ink and the blue ink in the same manner as in the case of the red ink described above, the green ink and the blue ink can be each supplied to the space (concave portion 18) that is between the partition members 20 and is spaced by two lines in the column direction Y.

In the present embodiment, a red ink, a green ink, and a blue ink that comprise a polymerizable compound that is polymerizable by applying energy thereto are supplied by a nozzle printing method. As the ink, a red ink, a green ink, and a blue ink that comprise, as the polymerizable compound, a light-emitting material having a polymerizable group that is polymerizable by applying energy may be used, or a red ink, a green ink, and a blue ink that comprise both a light-emitting material that is unpolymerizable itself and a polymerizable compound having a polymerizable group that is polymerizable may be used. Light-emitting materials used in the red ink, the green ink, and the blue ink will be described below.

Examples of the polymerizable group may include a vinyl group, an ethynyl group, a butenyl group, an acryloyl group, an acryloylamino group, a methacryloyl group, a methacryloylamino group, a vinyloxy group, a vinylamino group, a silanol group, a cyclopropyl group, a cyclobutyl group, an epoxy group, an oxetanyl group, a diketenyl group, an epithio group, a lactonyl group, and a lactamnyl group.

Examples of the polymerizable compound may include derivatives of PDA (N,N'-tetraphenyl-1,4-phenylenediamine) having a polymerizable group, derivatives of TPD (N,N'-bis(3-methylphenyl)-N,N'-bis(phenyl)-benzidine) having a polymerizable group, derivatives of NPD (N,N'-bis(naphthalen-1-yl)-N,N'-bis(phenyl)-benzidine) having a polymerizable group, triphenylamine acrylate, triphenylenediamine acrylate, phenylene acrylate, bisphenoxyethanolfluorene diacrylate (manufactured by Osaka Gas Chemicals Co., Ltd. under the trade name BPEF-A), dipentaerythritol hexaacrylate (KAYARD DPHA manufactured by Nippon Kayaku Co., Ltd.), trispentaerythritol octaacrylate (manufactured by KOEI CHEMICAL CO., LTD.) 1,4-butanediol diacrylate (manufactured by Alfa Aesar), and ARONE OXETANE (OXT121; a crosslinking agent manufactured by TOAGOSEI CO., LTD.). Preferred among these is phenylfluorene acrylate.

As described above referring to FIGS. 3A, 3B, and 3C, energy is then applied to the thin film 23 in the light-emitting region 11a, out of the thin film 23 made of the red ink, the green ink, and the blue ink, to make the thin film 23 in the light-emitting region 11a insoluble. Described in the present embodiment is the case where the red ink, the green ink, and the blue ink that comprises the polymerizable compound are used.

First, as illustrated in FIG. 3A, the mask 19 having the portion 19a that transmits near-infrared light (nIR) and the portion 19b that transmits no near-infrared light (nIR) is arranged on the supporting substrate 11. Near-infrared light (nIR) is emitted to the thin film through the mask 19 so that near-infrared light (nIR) is emitted only to the thin film 23 in the light-emitting region 11a. During this irradiation, the mask 19 cuts off part of the near-infrared light (nIR) so that no near-infrared light (nIR) is emitted to the thin film 23 outside the light-emitting region 11a. Thus, only the thin film 23 in the light-emitting region 11a is heated, and therefore only the thin film 23 in the light-emitting region 11a is made insoluble, thereby forming the insoluble thin film 23a.

### (Step of Removing Thin Film outside Light-Emitting Region by Cleaning)

Next, the thin film 23 outside the light-emitting region 11a is removed by cleaning. The method of cleaning may be a method of supplying a solvent onto the supporting substrate 11 and then removing the solvent (spin cleaning, for example), or a method of immersing the supporting substrate 11 in a solvent for a prescribed period of time, followed by taking the supporting substrate 11 out of the solvent to dry. In cleaning, a solvent that dissolves the thin film 23 that is not made insoluble and does not dissolve the insoluble thin film 23a is used. Examples of the solvent that can be used may include xylene, toluene, THF (tetrahydrofuran), and anisole. The same solvent as in the red ink, the green ink, and the blue ink may be used in cleaning of the thin film 23 outside the light-emitting region 11a.

In the present embodiment, the thin film 23 is made insoluble by heating with near-infrared light (nIR) irradiation. However, the method of making the thin film 23 insoluble is not limited thereto, and the thin film may be made insoluble with light energy by performing ultraviolet radiation or the like to emit light having a wavelength at which the polymerizable compound polymerizes.

After the thin film 23 outside the light-emitting region 11a is removed by cleaning, the solvent in the insoluble thin film 23a in the light-emitting region 11a is removed, where appropriate. The solvent can be removed by air drying, heating and drying, vacuum drying, or the like, for example.

After forming the light-emitting layer 14, a prescribed organic layer or inorganic layer, or the like is formed by a prescribed method, where appropriate. The layer to be provided where appropriate may be formed by a prescribed coating method such as a printing method, an ink-jet printing method, and a nozzle printing method, or by a prescribed dry method.

### (Step of Forming Second Electrode)

Next, the second electrode 16 is formed. As described above, in the present embodiment, the second electrode 16 is formed all over the supporting substrate 11. Thus, the organic EL elements 22 can be formed on the supporting substrate 11.

As described above, by making the thin film 23 in the light-emitting region 11a insoluble, the thin film 23 outside the light-emitting region 11a can be easily removed by cleaning. Using such a method of removing the thin film, the light-emitting device can be manufactured with ease.

In the present embodiment, the thin film 23 made of the ink for hole injection layer is removed by cleaning prior to the step of forming the light-emitting layer 14. However, it may not be necessary to remove the thin film 23 made of the ink for hole injection layer prior to the step of forming the light-emitting layer 14. In the case where a monomolecular layer (a monomolecular layer made of tetrafluorotetracyanoquinodimethane (F₄TCNQ), for example) having a hole injection characteristic is used as the hole injection layer, for example, it is not necessary to remove the hole injection layer that is formed outside the display region 11a because there is no significant degradation in hermeticity and hermetical sealing at the time of sealing, nor a risk of significant degradation in the characteristics of the display device. Alternatively, the thin film 23 made of the ink for hole injection layer may be removed simultaneously with the removal of the thin film made of the red ink, the green ink, or the blue ink by cleaning in the step of forming the light-emitting layer 14. In the case where the thin film 23 made of the ink for hole injection layer is less prone to dissolve in the red ink, the green ink, and the blue ink, for example, it might not be necessary to make the thin film 23 made of the ink for hole injection layer insoluble.

In the present embodiment, the thin film made of the red ink, the green ink, or the blue ink is made insoluble after the red ink, the green ink, and the blue ink are all supplied, followed by cleaning. However, the thin film made of the red ink, the green ink, or the blue ink may be made insoluble every time each of the red ink, the green ink, and the blue ink is supplied, followed by cleaning. By this step, a problem where the organic EL element 22 that is intrinsically to be supplied only with the blue ink is contaminated by the red ink that had dissolved at the time of cleaning, resulting in degradation in the characteristics of the display device, and similar problems are less prone to occur.

### <Structure of Organic EL Element>

The organic EL element 22 can have various layer structures, as described above. The layer structure of the organic EL element 22, the structure of each layer, and the method for forming each layer are described below in further detail.

As described above, the organic EL element 22 has the pair of electrodes composed of the anode and the cathode (the first electrode 12 and the second electrode 16) and one or more organic EL layers provided between the pair of electrodes, and has at least one light-emitting layer 14 as the organic EL layers. The organic EL element 22 may have a layer comprising both an inorganic substance and an organic substance, an inorganic layer, and the like. The organic substance that constitutes the organic layer may be a low molecular compound, a macromolecular compound, or a mixture of a low molecular compound and a macromolecular compound. The organic layer preferably contains a macromolecular compound. The organic layer preferably comprises a macromolecular compound having a number average molecular weight of 10³ to 10⁸ in terms of polystyrene.

The organic EL layer provided between the cathode and the light-emitting layer 14 may be the electron injection layer, the electron transport layer, the hole block layer, or the like. In the case where both of the electron injection layer and the electron transport layer are interposed between the cathode and the light-emitting layer 14, the layer closer to the cathode is called the electron injection layer, while the layer closer to the light-emitting layer 14 is called the electron transport layer. The organic EL layer provided between the anode and the light-emitting layer may be the hole injection layer, the hole transport layer, the electron block layer, or the like. In the case where both of the hole injection layer and the hole transport layer are provided, the layer closer to the anode is called the hole injection layer, while the layer closer to light-emitting layer is called the hole transport layer.

Examples of layer structures applicable to the organic EL element 22 of the present embodiment are described below.
a) anode / light-emitting layer / cathode
b) anode / hole injection layer / light-emitting layer /cathode
c) anode / hole injection layer / light-emitting layer /electron injection layer / cathode
d) anode / hole injection layer / light-emitting layer /electron transport layer / cathode
e) anode / hole injection layer / light-emitting layer /electron transport layer / electron injection layer /cathode
f) anode / hole transport layer / light-emitting layer /cathode
g) anode / hole transport layer / light-emitting layer /electron injection layer / cathode
h) anode / hole transport layer / light-emitting layer /electron transport layer / cathode
i) anode / hole transport layer / light-emitting layer /electron transport layer / electron injection layer /cathode
j) anode / hole injection layer / hole transport layer /light-emitting layer / cathode
k) anode / hole injection layer / hole transport layer /light-emitting layer / electron injection layer / cathode
l) anode / hole injection layer / hole transport layer /light-emitting layer / electron transport layer / cathode
m) anode / hole injection layer / hole transport layer /light-emitting layer / electron transport layer / electron injection layer / cathode
n) anode / light-emitting layer / electron injection layer / cathode
o) anode / light-emitting layer / electron transport layer / cathode
p) anode / light-emitting layer / electron transport layer / electron injection layer / cathode
The "forward slash (/)" indicates that the layers across a slash (/) are adjacently stacked. The same applies hereinafter.

The organic EL element 22 of the present embodiment may also have two or more light-emitting layers 14. The structure of the organic EL element 22 having two light-emitting layers 14 may be a layer structure of q) below where a stacked body sandwiched between an anode and a cathode in any one of the layer structures a) to p) described above is indicated by a "structural unit A". The layer structures of the two (structural units A) may be the same or different from each other.
q) anode / (structural unit A) / charge generation layer /(structural unit A) / cathode
   The structure of the organic EL element having three or more light-emitting layers may be a layer structure of r) below where "(structural unit A) / charge generation layer" is indicated by a "structural unit B".
r) anode / (structural unit B)x / (structural unit A) /cathode
In this structure, a symbol "x" is an integer of two or more, and (structural unit B)x is a stacked body in which the structural unit B is stacked x times. The layer structures of the "structural units B" may be the same or different from each other.

The charge generation layer is a layer generating holes and electrons when electric field is applied thereto. Examples of the charge generation layer may include a thin film made of vanadium oxide, indium tin oxide (ITO), molybdenum oxide, and the like.

In the organic EL element 22, the anode out of the pair of electrodes composed of the anode and the cathode may be arranged on the supporting substrate closer to the supporting substrate 11 than the cathode, or the cathode may be arranged on the supporting substrate 11 closer to the supporting substrate 11 than the anode. For example, in a) to r) described above, each layer may be stacked on the supporting substrate 11 from the right to constitute the organic EL element 22, or each layer may be stacked on the supporting substrate 11 from the left to constitute the organic EL element 22. The order of the layers to be stacked, the number of the layers, and the thickness of each layer (film thickness) can be designed as appropriate in consideration of light-emitting efficiency and the element life.

Next, the material of each layer that constitutes the organic EL element 22 and the method for forming the layer is more specifically described.

### <Anode>

In the structure where light emitted by the light-emitting layer 14 is output through the anode to the outside of the organic EL element, an electrode having light transparency is used as the anode. As the electrode having light transparency, a thin film of a metal oxide, a metal sulfide, a metal, or the like can be used, and those having high electric conductivity and high light transparency are preferably used. Specifically as the electrode having light transparency, a thin film made of indium oxide, zinc oxide, tin oxide, ITO, indium zinc oxide (IZO), gold, platinum, silver, copper, or the like is used. Among these, a thin film made of ITO, IZO, or tin oxide is preferably used.

Examples of the method of making the anode may include a vacuum deposition method, a sputtering method, an ion plating method, and a plating method. As the anode, an organic transparent conductive film of polyaniline or a derivative thereof, polythiophene or a derivative thereof, or the like may be used.

The film thickness of the anode is appropriately designed in consideration of characteristics required, easiness of the film forming step, and the like. The film thickness of the anode is, for example, 10 nm to 10 µm, is preferably 20 nm to 1 µm, and is further preferably 50 nm to 500 nm.

### <Cathode>

A preferred material of the cathode has a small work function, facilitates electron injection into the light-emitting layer 14, and has high conductivity. In the organic EL element in which light is extracted from the anode, the material of the cathode preferably has high visible light reflectance because the cathode reflects the light output from the light-emitting layer 14 to the anode. For example, alkali metals, alkaline-earth metals, transition metals, Group 13 metals in the periodic table, and the like can be used in the cathode. The material of the cathode to be used may be: metals such as lithium, sodium, potassium, rubidium, cesium, beryllium, magnesium, calcium, strontium, barium, aluminum, scandium, vanadium, zinc, yttrium, indium, cerium, samarium, europium, terbium, and ytterbium; alloys of two or more species of the metals; alloys of one or more species of the metals and one or more species from gold, silver, platinum, copper, manganese, titanium, cobalt, nickel, tungsten, and tin; or graphite and graphite intercalation compounds. Examples of the alloy may include magnesium-silver alloys, magnesium-indium alloys, magnesium-aluminum alloys, indium-silver alloys, lithium-aluminum alloys, lithium-magnesium alloys, lithium-indium alloys, and calcium-aluminum alloys. As the cathode, a transparent conductive electrode made of a conductive metal oxide, a conductive organic substance, or the like can be used. Specific examples of the conductive metal oxide may include indium oxide, zinc oxide, tin oxide, ITO, and IZO. Examples of the conductive organic substance may include polyaniline or derivatives thereof, and polythiophene or derivatives thereof. The cathode may be a stacked body in which two or more layers are stacked. The electron injection layer may be used as the cathode.

The film thickness of the cathode is appropriately designed in consideration of characteristics required, easiness of the film forming step, and the like. The film thickness of the cathode is, for example, 10 nm to 10 µm, is preferably 20 nm to 1 µm, and is further preferably 50 nm to 500 nm.

Examples of the method for forming the cathode may include a vacuum deposition method, a sputtering method, and a lamination method by which a metal thin film is thermocompression bonded.

### <Hole Injection Layer>

Examples of the hole injection material of the hole injection layer 13 may include oxides such as vanadium oxide, molybdenum oxide, ruthenium oxide, and aluminum oxide, phenylamine compounds, starburst-type amine compounds, phthalocyanine compounds, amorphous carbon, polyaniline, and polythiophene derivatives.

The film thickness of the hole injection layer 13 is appropriately designed in consideration of characteristics required, easiness of the film forming step, and the like. The film thickness of the hole injection layer 13 is, for example, 1 nm to 1 µm, is preferably 2 nm to 500 nm, and is further preferably 5 nm to 200 nm.

### <Hole Transport Layer>

Examples of the hole transport material of the hole transport layer may include polyvinylcarbazole or derivatives thereof, polysilane or derivatives thereof, polysiloxane derivatives having an aromatic amine on a side chain or the main chain, pyrazoline derivatives, arylamine derivatives, stilbene derivatives, triphenyldiamine derivatives, polyaniline or derivatives thereof, polythiophene or derivatives thereof, polyarylamines or derivatives thereof, polypyrrole or derivatives thereof, poly(p-phenylene vinylene) or derivatives thereof, and poly(2,5-thienylene vinylene) or derivatives thereof.

The film thickness of the hole transport layer is designed in consideration of characteristics required, easiness of the film forming step, and the like. The film thickness of the hole transport layer is, for example, 1 nm to 1 µm, is preferably 2 nm to 500 nm, and is further preferably 5 nm to 200 nm.

### <Light-emitting Layer>

In general, the light-emitting layer 14 is mainly made of an organic substance that emits any one of fluorescence and phosphorescence or both, or of the organic substance and a dopant assisting the organic substance. The dopant is added in order to improve the light-emitting efficiency and change the emission wavelength, for example. The organic substance constituting the light-emitting layer may be a low molecular compound or a macromolecular compound, and in the case of forming the light-emitting layer by a coating method, the light-emitting layer preferably comprises a macromolecular compound. The number average molecular weight of the macromolecular compound constituting the light-emitting layer is, for example, about 10³ to 10⁸ in terms of polystyrene. Examples of the light-emitting material of the light-emitting layer may include pigment materials, metal complex materials, polymer materials, and dopant materials to be described below.

### (Pigment Material)

Examples of the pigment materials may include cyclopentamine derivatives, tetraphenyl butadiene derivative compounds, triphenylamine derivatives, oxadiazole derivatives, pyrazoloquinoline derivatives, distyrylbenzene derivatives, distyrylarylene derivatives, pyrrole derivatives, thiophene ring compounds, pyridine ring compounds, perinone derivatives, perylene derivatives, oligothiophene derivatives, oxadiazole dimers, pyrazoline dimers, quinacridone derivatives, and coumarin derivatives.

### (Metal Complex Material)

Examples of the metal complex materials may include metal complexes having, as a central metal, a rare-earth metal such as Tb, Eu, and Dy, Al, Zn, Be, Ir, Pt, or the like and having, as a ligand, a structure of oxadiazole, thiadiazole, phenylpyridine, phenylbenzimidazole, quinoline, or the like. Examples of the metal complexes may include metal complexes that emit light from the triplet excited state such as iridium complexes and platinum complexes, aluminum-quinolinol complexes, benzoquinolinol beryllium complexes, benzoxazolyl zinc complexes, benzothiazole zinc complexes, azomethyl zinc complexes, porphyrin zinc complexes, and phenanthroline europium complexes.

### (Macromolecular Material)

Examples of the macromolecular materials may include polyparaphenylene vinylene derivatives, polythiophene derivatives, polyparaphenylene derivatives, polysilane derivatives, polyacetylene derivatives, polyfluorene derivatives, polyvinylcarbazole derivatives, and polymerized materials of the pigment materials or the metal complex materials described above.

The thickness of the light-emitting layer is generally about 2 nm to 200 nm.

### <Electron Transport Layer>

As the electron transport material of the electron transport layer, known electron transport materials can be used. Examples of the electron transport material may include oxadiazole derivatives, anthraquinodimethane or derivatives thereof, benzoquinone or derivatives thereof, naphthoquinone or derivatives thereof, anthraquinone or derivatives thereof, tetracyanoanthraquinodimethane or derivatives thereof, fluorenone derivatives, diphenyldicyanoethylene or derivatives thereof, diphenoquinone derivatives, metal complexes of 8-hydroxyquinoline or of derivatives of 8-hydroxyquinoline, polyquinoline or derivatives thereof, polyquinoxaline or derivatives thereof, or polyfluorene or derivatives thereof.

The film thickness of the electron transport layer is appropriately designed in consideration of characteristics required, easiness of the film forming step, and the like. The film thickness of the electron transport layer is, for example, 1 nm to 1 µm, is preferably 2 nm to 500 nm, and is further preferably 5 nm to 200 nm.

### <Electron Injection Layer>

As the material of the electron injection layer, an optimum material is selected as appropriate depending on the species of the light-emitting layer. Examples of the material of the electron injection layer may include: an alkali metal; an alkaline-earth metal; an alloy that comprise one or more species of alkali metals and an alkaline-earth metal; an oxide of an alkali metal or an alkaline-earth metal; a halide of an alkali metal or an alkaline-earth metal; a carbonate of an alkali metal or an alkaline-earth metal; or a mixture of these substances. Examples of the alkali metal, the oxide of alkali metal, the halide of the alkali metal, and the carbonate of the alkali metal may include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. Examples of the alkaline-earth metal, the oxide of the alkaline-earth metal, the halide of the alkaline-earth metal, and the carbonate of the alkaline-earth metal may include magnesium, calcium, barium, strontium, magnesium oxide, magnesium fluoride, calcium oxide, calcium fluoride, barium oxide, barium fluoride, strontium oxide, strontium fluoride, and magnesium carbonate. The electron injection layer may also be a stacked body in which two or more layers are stacked. Examples of the stacked body may include a stacked body of a LiF film and a Ca film.

The film thickness of the electron injection layer is preferably about 1 nm to 1 µm.

In the case where the organic EL layers comprise a plurality of organic EL layers that can be formed by a coating method, all the organic EL layers are preferably formed by a coating method. However, for example, it is possible to form, by a coating method, at least one layer of the organic EL layers that can be formed by a coating method while forming the other organic EL layers by a method other than coating methods. In the case where a plurality of organic EL layers are formed by a coating method, the organic EL layers may be formed by coating methods in which specific methods are different from each other. For example, although the hole injection layer 13 and the light-emitting layer 14 are formed by a nozzle printing method in the present embodiment, it is possible to form the hole injection layer 13 by a spin coating method while forming the light-emitting layer 14 by a nozzle printing method.

In a coating method, an ink comprising the organic EL material of each organic EL layer is applied for film forming to form the organic EL layer, and the solvent in the ink used is, for example, a chlorine solvent such as chloroform, methylene chloride, and dichloroethane; an ether solvent such as tetrahydrofuran; an aromatic hydrocarbon solvent such as toluene and xylene; a ketone solvent such as acetone and methyl ethyl ketone; an ester solvent such as ethyl acetate, butyl acetate, and ethyl cellosolve acetate; water; or the like.

Examples of the method, other than coating methods, that may be used to form the organic EL layer may include a vacuum deposition method, a sputtering method, a CVD method, and a lamination method.

### EXPLANATIONS OF LETTERS OR NUMERALS

- 1, 20: partition member
- 2, 17: partition
- 3, 22: organic EL element
- 4: nozzle
- 11: supporting substrate
- 11a: light-emitting region
- 12: first electrode
- 13: hole injection layer
- 14: light-emitting layer
- 15: insulating film
- 15a: opening
- 16: second electrode
- 18: concave portion
- 19: mask
- 19a: portion that transmits near-infrared light
- 19b: portion that transmits no near-infrared light
- 21: light-emitting device
- 23: thin film
- 23a: insoluble thin film

## Claims

1. A method for manufacturing a light-emitting device comprising a supporting substrate and a plurality of organic electroluminescent elements that are provided at a light-emitting region defined on the supporting substrate, each element comprising a first electrode, a second electrode, and an organic electroluminescent layer provided between the first electrode and the second electrode, the method comprising the steps of:
preparing the supporting substrate that has the first electrode;
supplying a ink that comprises a material to be the organic electroluminescent layer to the supporting substrate, and forming a thin film comprising the ink on the light-emitting region and a region outside the light-emitting region;
making the thin film in the light-emitting region insoluble;
removing the thin film in the region except the light-emitting region by cleaning; and
forming the second electrode.

2. The method for manufacturing the light-emitting device according to claim 1,
wherein, at the step of forming a thin film comprising the ink, the ink comprising a polymer compound is supplied; and
at the step of making the thin film insoluble, the thin film in the light-emitting region is made insoluble by polymerizing the polymer compound.

3. The method for manufacturing the light-emitting device according to claim 1,
wherein, at the step of making the thin film insoluble, the thin film in the light-emitting region is made insoluble by light radiation.

4. The method for manufacturing the light-emitting device according to claim 1,
wherein at the step of making the thin film insoluble, the thin film in the light-emitting region is made insoluble by heating.

5. The method for manufacturing the light-emitting device according to claim 4,
wherein the thin film in the light-emitting region is heated by near-infrared radiation.

6. The method for manufacturing the light-emitting device according to claim 1,
wherein, at the step of forming the thin film, the ink is supplied by a nozzle printing method.
